# EUROPEAN PATENT SPECIFICATION

(11) **EP 0 343 578 B1**
(45) Date of publication and mention of the grant of the patent: **10.11.1993**
(21) Application number: 89109218.1
(22) Date of filing: 23.05.1989
(51) Int. Cl.: B60R 21/32

(54) **Releasing circuit for actuating vehicular safety device**
Auslöseschaltkreis für Fahrzeugsicherheitsvorrichtung
Circuit de mise en marche pour dispositif de sécurité de véhicule

(30) Priority: 23.05.1988 JP 125343/88
(43) Date of publication of application: 29.11.1989
(73) Proprietor: NIPPONDENSO CO., LTD., Kariya-shi Aichi-ken (JP)
(72) Inventor: Kondo, Akira, Okazaki-shi Aichi-ken (JP); Naitou, Motoharu, Okazaki-shi Aichi-ken (JP); Ota, Toshiaki, Anjo-shi Aichi-ken (JP); Masegi, Mitsuhiko, Nukata-gun Aichi-ken (JP); Sakurai, Masao, Ohbu-shi Aichi-ken (JP)
(74) Representative: Blumbach Weser Bergen Kramer

(56) References cited:
- WO-A-88/01241
- DE-A- 2 808 872
- FR-A- 2 184 307
- US-A- 4 059 822
- US-A- 4 158 191
- US-A- 4 359 715
- US-A- 4 695 075

## Description

The present invention relates to vehicular safety devices such as air cushions, belt tighteners or similar arrangements, and more particularly to a control circuit for activating a releasing circuit for the safety device in a more reliable manner, according to the preamble of claim 1.

In such a releasing circuit for the safety device as described above, a checking circuit is provided to check a defect or malfunction in the releasing circuit. The checking circuit is, in general, designed to always supply an electric current from a vehicle battery to an ignition element of the safety device thereby to render the ignition element in an operable condition for checking. For this reason, it is required to reduce the power consumption of the battery as small as possible. It is also assumed that when the vehicle has been subjected to an accident, the ignition element may not be activated due to disconnection from the battery. For the purpose of avoiding such a problem, a capacitor is adapted as a back up power source for supplying a charged voltage therefrom to the ignition element, wherein the capacitor is arranged to be previously charged by the power from the battery. There will, however, occur a lapse of time due to the characteristic of an acceleration sensor prior to supply of the charged voltage from the capacitor to the ignition element. If in this instance a large amount of electric current was supplied to the checking circuit from the capacitor before the lapse of time, the ignition element would not be activated due to insufficient supply of the charged voltage from the capacitor. Such or comparable arrangements are known from US-A-4,059,822, US-A-4,158,191, US-A-4,695,075, WO-A-88-01241, FR-A- 21 84 307 and DE-A-28 08 872 and in particular from US-A-4,359,715 which forms the preamble of claim 1.*)
*) This primary object is solved by a releasing circuit according to claim 1. Advantageous embodiments are defined by the features in the subclaims.

It is, therefore, a primary object of the present invention to provide a control circuit for the releasing circuit capable of activating the ignition element in a more reliable manner without causing an undesired power consumption of an electric power source.

According to the present invention, the advantages and the technical advance are based on a releasing circuit for actuating a safety device to protect passengers of a vehicle, comprising an acceleration sensor arranged to provide an electric acceleration signal responsive to acclerations of the vehicle and an evaluating circuit for setting a predetermined condition for actuating an ignition element of the safety device and responsive to the acceleration signal from the sensor for effecting the activation of said ignition element when the predetermined condition has been satisfied by the acceleration signal,
wherein a control circuit for the releasing circuit comprises:
first means responsive to an output signal from the evaluating circuit for controlling the electric power supply to the ignition element from an electric power source;
second means responsive to the output signal from the evaluating circuit for controlling the first means in such a manner that the first means acts to maintain the electric power supplied to the ignition element at a predetermined small value until the condition for activation of the ignition element is satisfied by the acceleration signal and for controlling the first means in such a manner that the first means acts to increase the electric power supplied to the ignition element up to a predetermined large value when the condition for activation of the ignition element has been satisfied by the acceleration signal; and
third means for prohibiting an increase of the electric power under control of the second means in a condition where the ignition element has to be maintained inoperative.

For a better understanding of the present invention, and to show how the same may be carried into effect, reference will now be made, by way of example, to the accompanying drawings, in which:
Fig. 1 is a partly cut away elevation of an automobile equipped with an air cushion system for the driver;
Fig. 2 is a circuit diagram of a releasing circuit with a control circuit in accordance with the present invention;
Fig. 3 is a flow chart of a program executed by a computer in the control circuit;
Fig. 4 is a circuit diagram of a modification of the control circuit shown in Fig. 2; and
Fig. 5 is a circuit diagram of another modification of the control circuit shown in Fig. 2.

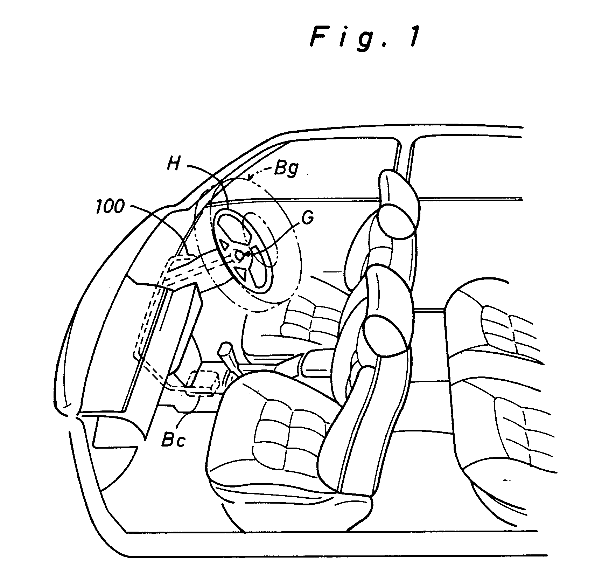

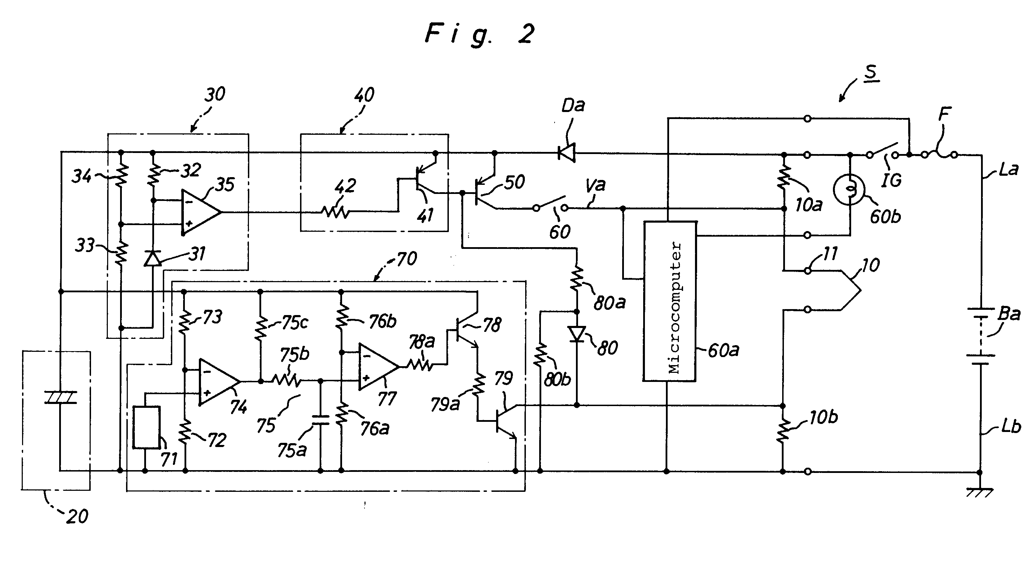

Disclosed in Fig. 1 of the drawings is an automobile equipped with an air cushion system which includes an air bag Bg for the driver disposed within a steering wheel H, a gas generator G mounted in the air bag Bg, and a releasing circuit unit S in a control box Bc arranged in the vehicle compartment. The gas generator G is provided therein with an ignition element 10 which is energized by an input current applied thereto under control of the releasing circuit unit S to burst the gas generator G for rapidly inflating the air bag Bg. As shown in Fig. 2, the releasing circuit unit S comprises a back-up power supply source in the form of a capacitor 20 which is grounded at its one end and connected at its other end to the positive terminal of a main power supply source in the form of a vehicle battery Ba through a diode Da, a vehicle ignition switch IG, a fuse F and a power source line La. The capacitor 20 is charged by DC voltage applied thereto from the battery Ba through the power source line La, fuse F, ignition switch IG and diode Da. The electrostatic capacity of capacitor 20 is determined in a large value taking into account of a predetermined amount of an electric current which flows continuously into the ignition element 10 for a predetermined time duration to activate the ignition element 10. In addition, the negative terminal of battery Ba is grounded through a power source line Lb.

A voltage detection circuit 30 includes a zener diode 31 which is arranged to be turned on in response to the DC voltage applied thereto from the battery Ba through the power source line La, fuse F, ignition switch IG, diode Da and a resistor 32 for generating a reference voltage at its output terminal. A pair of resistors 33, 34 are connected in series with each other and arranged to generate a detection voltage at their common terminal when applied with the DC voltage from battery Ba through the power source line La, fuse F, ignition switch IG and diode Da. A comparator 35 is arranged to compare the detection voltage from resistors 33, 34 with the reference voltage from zener diode 31. When the detection voltage is lower than the reference voltage, the comparator 35 generates a low level signal therefrom. When the detection voltage is higher than the reference voltage, the comparator 35 generates a high level signal therefrom. In this embodiment, the low level signal from comparator represents an abnormal condition of the DC voltage, whereas the high level signal from comparator 35 represents a normal condition normal of the DC voltage.

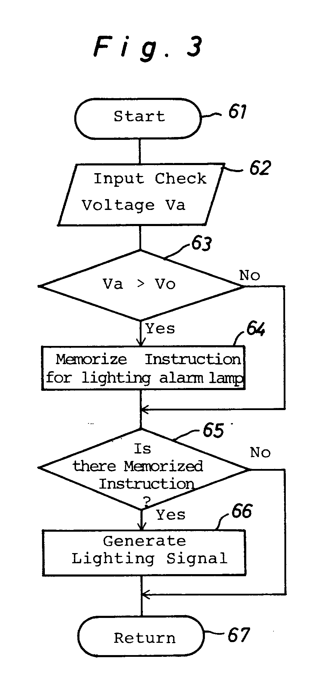

A prohibition circuit 40 includes a transistor 41 arranged to be turned on when applied with the low level signal from comparator 35 through a resistor 42 and to be turned off in response to the high level signal applied thereto from comparator 35. The emitter of transistor 41 is grounded through the capacitor 20 and connected to the positive terminal of battery Ba through diode Da, ignition switch IG, fuse F and power supply line La. A transistor 50 is connected at its base directly to the collector of transistor 41. The emitter of transistor 50 is grounded through the capacitor 20 and connected to the ignition switch IG through diode Da. The transistor 50 is arranged to be activated in accordance with a bias voltage applied thereto from the transistor 41. An acceleration switch 60 of the normally open type is in the form of a mercury switch which is connected at its one end to the collector of transistor 50 and at its other end to the ignition switch IG through a resistor 10a with a high resistance value. The switch 60 is further grounded at its other end through the ignition element 10 and a resistor 10b with a high resistance value. When the vehicle acceleration is maintained to be equal to or higher than a predetermined low value, the acceleration switch 60 is closed to short the ignition element 10 to the collector of transistor 50. A microcomputer 60a is arranged to cooperate with the acceleration switch 60 to execute a computer program for control of an alarm lamp 60b as shown by a flow chart in Fig. 3. The computer program is previously stored in the read-only memory or ROM of computer 60a. The computer 60a is always maintained in an operative condition by the electric power supplied thereto from battery Ba through power source line La and fuse F.

An evaluating circuit 70 includes an accleration sensor 71 which dectects the vehicle acceleration to generate therefrom an acceleration voltage indicative of the vehicle acceleration. The acceleration sensor 71 has a delay characteristic in its operation dependent on the vehicle acceleration. A pair of resistors 72, 73 are connected in series with each other and arranged to generate a reference voltage at their common terminal when applied with the charged voltage from capacitor 20 or the DC voltage from battery Ba through power source line La, fuse F, ignition switch IG and diode Da. The reference voltage defined by resistors 72, 73 corresponds to a slight low acceleration than that caused by an abnormal sudden change of the vehicle acceleration. A comparator 74 is arranged to generate a low level signal therefrom when applied with the acceleration voltage from sensor 71 at a lower level than the reference voltage defined by resistors 72, 73 and to generate a high level signal therefrom when applied with the acceleration voltage from sensor 71 at a higher level than the reference voltage.

An integrator 75 includes a capacitor 75a arranged to be charged in response to the high level signal from comparator 74 by the DC voltage applied thereto from battery Ba through power source line La, fuse F, ignition switch IG, diode Da and resistors 75c, 75b or the charged voltage applied thereto from the capacitor 20 through resistors 75c, 75b. In such an arrangement, the capacitor 75a generates an integration voltage at its output terminal when it has been charged. The integration voltage from capacitor 75a drops immediately after applied with the low level signal from comparator 74 through resistor 75b. A pair of resistors 76a, 76b are connected in series with each other and arranged to generate a reference voltage at their common terminal when applied with the DC voltage from battery Ba through power source line La, fuse F, ignition switch IG and diode Da or the charged voltage from capacitor 20. The reference voltage defined by resistors 76a, 76b corresponds to a predetermined voltage necessary for determining as to whether or not the vehicle acceleration has suddenly changed in an abnormal condition. A comparator 77 is arranged to generate a low level signal therefrom when applied with the integration voltage from capacitor 75a at a lower level than the reference voltage defined by resistors 76a, 76b and to generate a high level signal therefrom when applied with the integration signal from capacitor 75a at a higher level than the reference voltage. A transistor 78 is arranged to be turned on when applied with the high level signal from comparator 77 through a resistor 78a and to be turned off when applied with the low level signal from comparator 77. The collector of transistor 78 is grounded through the capacitor 20 and is further connected to the positive terminal of battery Ba through diode Da, ignition switch IG, fuse F and power source line La. A transistor 79 is biased by a resistor 79a to be turned on in response to activation of the transistor 78. The transistor 79 is inversely turned off in response to deactivation of the transistor 78. In this instance, the activation of transistor 79 represents the fact that the vehicle acceleration has suddenly changed in an abnormal condition, whereas the deactivation of transistor 79 represents the fact that the vehicle acceleration is maintained in a normal condition.

Hereinafter, the inventive subject matter of the present invention will be described in detail. A diode 80 has a cathode connected to the collector of transistor 79 and an anode connected to the base of transistor 50 through a resistor 80a and grounded through a resistor 80b. When the transistor 79 is being turned off, the diode 80 is inversely biased by a difference between resistance values of resistors 10b, 80b to be turned off. When the transistor 79 is being turned on, the diode 80 is grounded at its cathode through transistor 79 to be turned on.

In this embodiment, the resistance values of resistors 80a, 80b are determined taking into account of the following matters. For detecting a defect in short of the acceleration switch 60, it is needed to continuously flow a minute current through transistor 50, acceleration switch 60, ignition element 10 and resistor 10b in a condition where the acceleration switch 60 has been normally closed and maintained in the closed position. For this reason, the sum of resistance values of resistors 80a, 80b is determined in such a manner that the transistor 50 is applied at its base with a bias voltage necessary for flowing the minute current as mentioned above. For activating the ignition element 10 in a more reliable manner, it is necessary to apply a desired current of a few ampere (A) to the ignition element 10 for a predetermined time duration. For this reason, the resistance value of resistor 80a is determined in such a manner that the bias voltage of transistor 50 is controlled to apply the desired current to the ignition element 10 even if the battery Ba was disconnected from one of the power source lines La and Lb in an abnormal sudden change of the vehicle acceleration. On the other hand, the resistance value of resistor 80b is determined to inversely bias the diode 80 in response to deactivation of the transistor 79 and to control the bias voltage of transistor 50 for maintaining the minute current applied to the ignition element 10 during deactivation of the diode 80.

Assuming that in operation the comparator 35 of voltage detection circuit 30 is conditioned to generate a high level signal therefrom after the ignition switch IG was closed, the transistor 41 of prohibition circuit 40 is maintained in a deactivated condition. In such a condition, the transistor 50 is maintained at a low conductive state in accordance with a bias voltage defined by the sum of resistance values of resistors 80a and 80b. When the acceleration switch 60 is maintained in its normally open position, a check voltage Va appearing between the terminal 11 of ignition element 10 and the fixed terminal of acceleration switch 60 is defined by the ratio of the resistance value of resistor 10a against the sum of the resistance values of resistors 10a and 10b in relation to the DC voltage of battery Ba. When the check voltage Va is equal to or lower than a predetermined voltage Vo, the computer 60a receives the check voltage Va at a step 62 of the computer program shown in Fig. 3 to determine a "No" answer subsequently at steps 63 and 65.

In case the acceleration switch 60 is shorted in error, a minute current from battery Ba will be supplied to the ignition element 10 through transistor 50 and switch 60 under the low conductive state of transistor 50. Thus, the computer determines a "Yes" answer at step 63 to memorize at step 64 an instruction for lighting the alarm lamp 60b. Subsequently, the computer determines a "Yes" answer at step 65 to generate a lighting signal at step 66. As a result, the alarm lamp 60b is lighted in response to the lighting signal from computer 60a. In addition, the capacitor 20 is charged by the DC voltage applied thereto from battery Ba through power source line La, fuse F and diode Da. It is assumed that the battery Ba is disconnected from one of the power source lines La and Lb due to an abnormal sudden change of the vehicle acceleration in a condition where the acceleration switch 60 has been normally closed after the vehicle started. In this instance, the acceleration sensor 71 will generate an acceleration signal therefrom after lapse of a delay time, and in turn, the acceleration signal becomes higher than a reference voltage defined by resistors 72, 73 under the charged voltage from capacitor 20. Then, the comparator 74 generates a high level signal therefrom, and in turn, the intergrator 75 generates an integration voltage. In this instance, the transistor 79 is still maintained in a deactivated condition due to a low level signal from comparator 77. Thus, the base current of transistor 50 is restrained by resistors 80a, 80b to maintain the low conductive state of transistor 50. This is effective to minimize the consumption of electric energy supplied from the capacitor 20 after disconnection of battery Ba.

When the integration voltage from capacitor 75a exceeds the reference voltage from resistors 76a, 76b caused by the charged voltage from capacitor 20, the transistor 78 is turned on and, in turn, the transistor 79 is turned on to activate the diode 80. This means that the resistor 80b is shorted by diode 80. Thus, the transistor 50 is biased at its base deeply by the resistor 80a to facilitate its conductive state up to a saturation state. As a result, an amount of an electric current flowing into the transistor 79 from capacitor 20 through transistor 50, acceleration switch 60 and ignition element 10 increases up to the desired amount. In this instance, consumption of charged electric energy from capacitor 20 after disconnection of battery Ba is minimized as described above. Thus, in spite of disconnection of battery Ba, the electric current from capacitor 20 to ignition element 10 is maintained with the desired amount and time duration to activate the ignition element 10 so as to rapidly inflate the air bag Bg as shown by imaginary lines in Fig. 1.

As is understood from the above description, the base current of transistor 50 is maintained to be zero in a prohibited condition of the air cushion system, maintained to be a relatively small value capable of flowing a minute current through the acceleration switch 60 prior to activation of the ignition element 10, and maintained to be a relatively large value capable of flowing an sufficient current through the ignition element 10 at its activation. Thus, the consumption of electric energy of capacitor 20 can be effectively minimized, and the time duration for activating the ignition element 10 can be reliably ensured by capacitor 20.

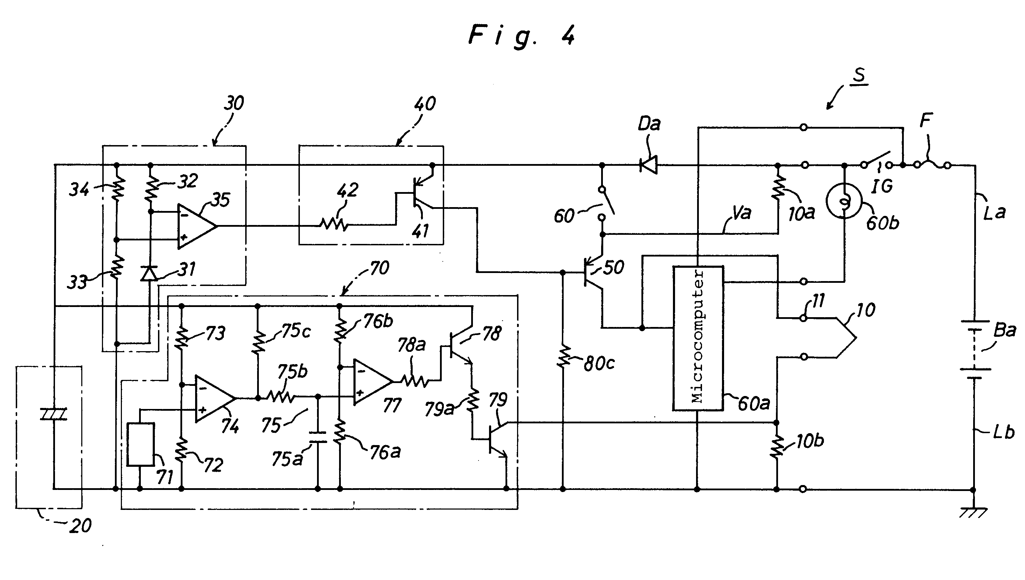

Fig. 4 illustrates a modification of the above embodiment. In this modification, the acceleration switch 60 is connected between the emitter of transistor 50 and the cathode of diode Da. The transistor 50 is grounded at its base through resistor 80c and connected at its emitter and collector to the resistor 10a and ignition element 10, respectively. In addition, the resistors 80a, 80b and diode 80 are eliminated. Other construction of the modification is substantially the same as that of the above embodiment.

In operation, when the transistor 41 is turned off in the same manner as described above, the transistor 50 is turned on at its low conductive state caused by the resistors 10a, 80c. In this instance, a check voltage Va under the normally opened condition of acceleration switch 60 is defined as the same as the above embodiment. Thus, the computer 60a executes the program in relation to the check voltage Va to determine as to whether or not the acceleration switch 60 is shorted.

When the battery Ba is disconnected from one of power source lines La, Lb under normal closure of acceleration switch 60, the transistor 79 is maintained in its deactivated condition. Therefore, even if the power supply from capacitor 20 in replacement of that from battery Ba is effected as decribed above, a base current of transistor 50 is limited by resistor 80c to restrain a current flowing through ignition element 10 in a value maintaining deactivation of the ignition element 10 in relation to resistor 10b. This is effective minimize the consumption of electric energy from capacitor 20 after disconnection of the battery Ba.

When the transistor 79 is turned on, the resistor 10b is shorted to maintain the current from capacitor 20 to the ignition element 10 in such a manner to reliably activate the ignition element 10. As is understood from the above description, consumption of electric energy from capacitor 20 to ignition element 10 can be minimized without surplus electric elements. In addition, the activation of transistor 50 is prohibited by activation of transistor 41.

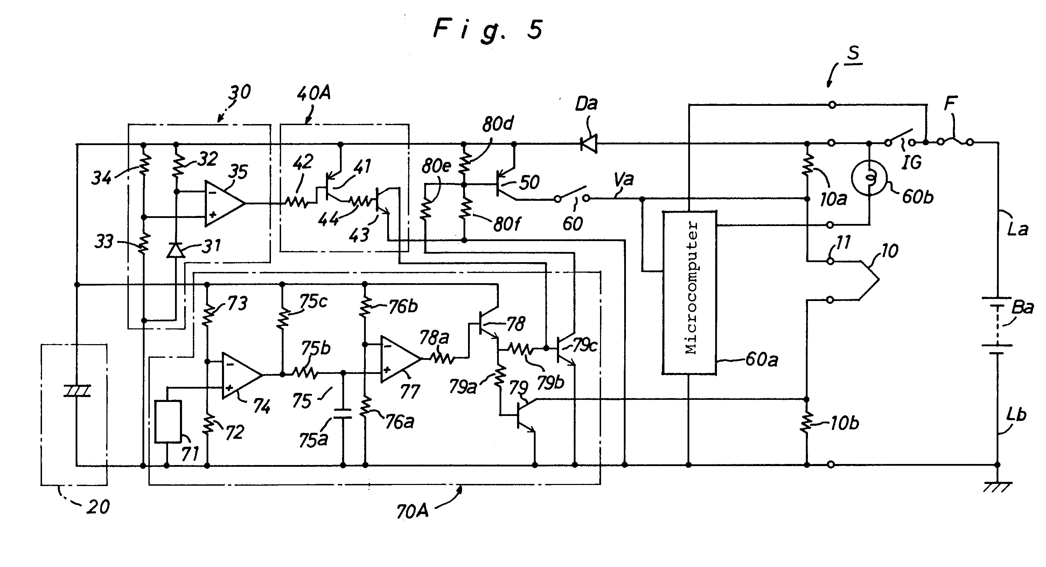

Fig. 5 illustrates another modification of the above embodiment wherein a prohibition circuit 40A and an evaluating circuit 70A are adapted in replacement of the evaluating circuit 40 and prohibition circuit 70, respectively and wherein resistors 80d, 80e, 80f are adapted in replacement of diode 80 and resistors 80a, 80b. The prohibition circuit 40A includes a transistor 43 and a resistor 44. The transistor 43 is turned on or off by resistor 44 in response to activation or deactivation of transistor 41. The transistor 43 is grounded at its emitter. Other construction of circuit 40A is substantially the same as that of circuit 40 in the above embodiment. The evaluating circuit 70A comprises a resistor 79b and a transistor 79c. The transistor 79c is connected at its base to the collector of transistor 43 and to the emitter of transistor 78 through resistor 79b. Thus, the transistor 79c is maintained in a deactivated condition in response to activation of the transistor 43. while the transistor 43 is maintained in a deactivated condition, the transistor 79c is turned on or off in response to activation or deactivation of the transistors 78, 79. Other construction of circuit 70A is substantially the same as that of circuit 70. A resistor 80d has one end connected to the emitter of transistor 50 and the other end connected to the base of transistor 50. The other end of resistor 80d is further connected through resistor 80e to the collector of transistor 70c and grounded through resistor 80f. In this case, a resistance value of resistor 80f is determined to be larger than that of resistor 80e. The resistors 80d, 80f are arranged to divide the DC voltage from battery Ba or charged voltage from capacitor 20 during deactivation of the transistor 79c into a divided voltage and to apply it to the base of transistor 50 as a bias voltage for activating the transistor 50 at its low conductive state. During activation of the transistor 79c, the resistors 80d, 80e are arranged to divide the DC or charged voltage into a divided voltage and to apply it to the base of transistor 50 as a bias voltage for activating the transistor 50 at its high conductive state. In addition, resistance values of resistors 80d, 80f are determined to restrain an electric current flowing into ignition element 10 in a value maintaining activation of element 10, even if the transistor 79 is turned on under deactivation of transistor 79c.

In operation, when the transistor 41 of prohibition circuit 40A is turned off in the same manner as described above, the transistor 43 is turned off. Thus, the transistor 50 is turned on at its low conductive state caused by the resistors 80d, 80f. In this instance, a check voltage Va under the normally opened condition of acceleration switch 60 is defined in the same manue as described above. Then, the computer 60a executes the program in relation to the check voltage Va to determine as to whether or not the acceleration switch 60 is shorted.

When the battery Ba is disconnected from one of power source lines La, Lb under normal closure of acceleration switch 60, the transistor 79 is maintained in its deactivated condition. Thus, the transistor 50 is maintained at its low conductive state by the resistors 80d, 80f, even if the power supply from capacitor 20 in replacement of that from battery Ba is effected as previously described. This is effective to minimize consumption of charged energy of capacitor 20 after disconnection of battery Ba.

When the transistor 79 is turned on, the resistor 10b is shorted, and transistor 79c is activated. Then, the transistor 50 is turned on at its high conductive state by the divided voltage from resistors 80d, 80e such that it maintains an electric current from capacitor 20 to ignition element 10 capable of reliably activating it. This is effective in high probability to minimize consumption of charged energy from capacitor 20 and to activate the ignition element.

In case that the transistor 43 is turned on, activation of transistor 79c is reliably prohibited regardless of activation of transistor 79. Thus, the transistor 50 is maintained at its low conductive state to prevent the ignition element 10 from its activation in spite of activation of transistor 79.

Although in the above embodiment the present invention has been adapted to a releasing circuit for an air cushion system, it may be adapted to a releasing circuit for a seat belt tightener or similar protective shock absorbing device.

While in the above embodiment and modifications a junction type transistor is adapted as the transistor 50, a field effect transistor or FET may be adapted as the transistor 50 in replacement of the junction type transistor. In the modification, it is preferrable that a control circuit for controlling an input voltage for the gate of FET is arranged to be controlled by the evaluating circuit 70 (or 70A) or acceleration switch 60. This is effective to decrease consumption of electric energy in the control circuit.

Although in the above embodiment and modifications the air cushion system is maintained inoperative under deactivation of transistor 50 caused by lowering of the voltage from battery Ba or capacitor 20 to a predetermined level, it may be also maintained inoperative by the instance detection of abnormal condition of the release circuit.

For the actual practice of the present invention the transistor 50 may be connected to a portion of the release circuit through which an electric current for activating the ignition element 10 flows. Although in the above embodiment the diode 80 is connected in series with the resistor 80a, it may be replaced with various semiconductor switch elements.

For the actual practice of the present invention, the present invention may be also adapted to a release circuit for a air cushion system without the back up power source in the form of capacitor 20. This is effective to decrease consumption of electric energy from battery Ba.

## Claims

1. A releasing circuit for a safety device, in particular for a vehicle, having a release element (10) supplied with a current sufficient for activation thereof from an electric power source (Ba, 20) through a current path (La), the safety device being actuated responsive to activation of the release element (Bg) to protect passengers of a vehicle,
with an evaluating means (70, 70A) for evaluating the actual vehicle condition in relation to a predetermined evaluating condition,
with a first means (50, 10a, 60) provided within said current path and for supplying a current to the release element from said power source through said current path (La), and with a second means including control means maintainable in a first and a second condition
characterized by the following features:
a) said evaluating means (70, 70A) is adapted for supplying sufficient current to the release element and for generating an evaluating signal when the evaluated result has satisfied the predetermined evaluating condition,
b) said first means (50, 10a, 60) is adapted for supplying a minute current continuously to the release element when controlled in a low conducting state thereof and for supplying sufficient current to the release element when controlled in a high conducting state thereof,
c) said first condition of said control means (10b, 79c, 80, 80a-80f) is a condition to control said first means (10a, 50, 60) in the low conducting state and said second condition is a condition to control said first means in the high conducting state, said second means being arranged for effecting the first condition of said control means (10b, 79c, 80, 80a-80f) when said evaluating means (70, 70A) does not produce any evaluating signal and for effecting the second condition of said control means in response to the evaluating signal from said evaluating means, and
d) wherein third means (30, 40, 40A) are provided for prohibiting operation of said first means upon detection of a predetermined prohibitive condition for prohibiting the supply of said sufficient current to the release element (Bg).

2. A releasing circuit according to claim 1, wherein said power source is a battery (Ba) and a capacitor (20), the capacitor being charged by said battery through said current path, and
wherein the release element is supplied with a current through said current path from at least one of said battery and said capacitor.

3. A releasing circuit according to one of claims 1 or 2, characterized in that said third means includes means (30) for detecting a decrease of an electric voltage from at least one of said battery and said capacitor to generate a detecting signal therefrom, said third means prohibiting operation of said first means in response to the detecting signal.

4. A releasing circuit according to one of claims 1 to 3, characterized in that said first means is a transistor circuit means (50, 10a, 60).

5. A releasing circuit according to one of claims 1 to 3, characterized in that said evaluating means includes an acceleration sensor (71) for providing an acceleration signal responsive to accelerations of the vehicle, and an evaluating circuit (72-78) for evaluating the acceleration signal from said acceleration sensor in relation to the predetermined evaluating condition and for generating an evaluating signal when the evaluated result has satisfied the predetermined evaluating condition.

6. A releasing circuit according to one of claims 1 to 5, wherein said first means includes semiconductor means (50) and a resistor (10a) with a high resistance value which are provided in parallel with each other within said current path, said semiconductor means supplying a minute current continuously to the release element from said power source through said resistor when controlled in a low conducting state thereof and supplying said sufficient current to the release element from said power source therethrough when controlled in a high conducting state thereof,
wherein said control means is maintainable in the first condition to control said semiconductor means in the low conducting state and maintainable in the second condition to control said semiconductor means in the high conducting state, and
wherein said third means prohibits operation of said semiconductor means in response to detection of the predetermined prohibitive condition. (Fig. 2)

7. A releasing circuit according to one of claims 4 or 6, characterized in that said semiconductor means (50) of said transistor circuit means includes a transistor (50).

8. A releasing circuit according to one of claims 1 to 7, characterized in that said first means includes:
switch means (60) and a resistor (10a) with a high resistance value which are provided in parallel with each other within said current path, said switch means shunting said resistor when actuated in response to an increase of the vehicle speed up to a predetermined low value, and
semiconductor means (50) associated with said switch means and said resistor and for supplying a minute current continuously to the release element from said power source therethrough when controlled in a low conducting state thereof and for supplying said sufficient current to the release element from said power source therethrough when controlled in a high conducting state thereof when said resistor is shunted,
wherein said control means (80c, 10b) is maintainable in the first condition to control said semiconductor means in the low conducting state and maintainable in the second condition to control said semiconducting state, and
wherein said third means (30, 40) prohibits operation of said semiconductor means in response to detection of the predetermined prohibitive condition. (Fig. 4)

9. A releasing circuit according to one of claims 1 to 7, characterized in that said second means includes semiconductor means (79) that is non-conductive when said evaluating means does not produce any evaluating signal and conductive in response to the evaluating signal from said evaluating means, and
wherein said control means is a bias circuit means (10b, 80, 80a, 80b) responsive to non-conduction of said semiconductor means for biasing said first means in the low conducting state and responsive to conduction of said semiconductor means for biasing said first means in the high conducting state. (Fig. 2)

10. A releasing circuit according to one of claims 1 to 3 or 5, characterized in that said first means includes semiconductor means (50) and a resistor (10a) with a high resistance value which are provided in parallel with each other within said current path, said semiconductor means supplying a minute current continuously to the release element from said power source through said resistor when controlled in a low conducting state thereof and for supplying said sufficient current to the release element from said power source therethrough when controlled in a high conducting state thereof,
wherein said second means includes semiconductor means (79) that is non-conductive when said evaluating means does not produce any evaluating signal and conductive in response to the evaluating signal from said evaluating means,
wherein said control means includes resistor means (80d-80f) responsive to non-conduction of said second-named semiconductor means for biasing said first-named semiconductor means in the low conducting state and responsive to conduction of said second-named semiconductor means for biasing said first-named semiconductor means in the high conducting state, and
wherein said third means (30, 40A) prohibits said second-named semiconductor means in response to detection of the predetermined prohibitive condition. (Fig. 5)

11. A releasing circuit according to one of claims 4,6 or 7, characterized in that said transistor circuit means includes a transistor (50) provided within said current path, said transistor circuit means supplying a minute current continuously to the release element from said power source through said transistor when said transistor is controlled in a low conducting state thereof and for supplying said sufficient current to the release element from said power source through said transistor ten said transistor is controlled in a high conducting state thereof,
wherein said second means includes semiconductor means (79) that is non-conductive when said evaluating means does not produce any evaluating signal and conductive in response to the evaluating signal from said evaluating means,
wherein said control means is a bias circuit means (10b,80a,80b) having a resistor circuit connected to the base of said transistor, and a diode (80) provided within said resistor circuit, said bias circuit means responsive to non-conduction of said semiconductor means for effecting non-conduction of said diode by way of said resistor circuit such that said transistor is controlled in its low conducting state and responsive to conduction of said semiconductor means for effecting conduction of said diode by way of said resistor circuit such that said transistor is controlled in its high conducting state, and
wherein said third means (30,40) prohibits operation of said transistor in response to detection of the predetermined prohibitive condition.

12. A releasing circuit according to claim 11, characterized in that said transistor circuit means includes switch means (60) provided within said current path in series with said transistor and closable in response to an increase in the vehicle speed up to a predetermined low value to effect the electric power supply to the ignition element through said transistor.

13. A releasing circuit according to claim 12, further comprising means (60a) for determining a defect or malfunction of said switch means as a function of an electric voltage appearing at said current path.

14. A releasing circuit according to one of claims 4,6 or 7, wherein said transistor circuit means includes a transistor (50) provided within said current path, said transistor circuit means supplying a minute current continuously to the release element from said power source through said transistor when said transistor is controlled in a low conducting state thereof and for supplying said sufficient current to the release element from said power source through said transistor when said transistor is controlled in a high conducting state thereof,
wherein said second means includes semiconductor means (79) which is non-conductive when said evaluating means does not produce any evaluating signal and conductive in response to the evaluating signal from said evaluating means,
wherein said control means includes a resistor circuit (80d-80f) connected to the base of said transistor and for biasing said transistor in the low conducting state in response to non-conduction of said semiconductor means and for biasing said transistor in the high conducting state in response to conduction of said semiconductor means, and
wherein said third means prohibits conduction of said semiconductor means in response to detection of the predetermined prohibitive condition.

## Patentansprüche

1. Auslöseschaltung für eine Sicherheitseinrichtung, insbesondere für ein Fahrzeug, mit einem Auslöseelement (10), dem ein ausreichender Strom zur Auslösung durch diesen aus einer elektrischen Leistungsquelle (Ba, 20) durch einen Strompfad (La) zugeführt ist, wobei die Sicherheitseinrichtung beim Auslösen in Ansprechen auf eine Aktivierung des Auslöseelementes (Bg) die Passagiere eines Fahrzeugs schützt,
mit einer Auswerteeinrichtung (70, 70a) zum Auswerten des tatsächlichen Fahrzeugzustands im Verhältnis zu einem vorbestimmten Auswertezustand,
mit einer ersten Einrichtung (50, 10a, 60), die innerhalb des Strompfades und zum Zuführen eines Stroms zu dem Auslöseelement von der Stromquelle durch den Strompfad (LA) angeordnet ist und
mit einer zweiten Einrichtung, die eine in einem ersten und einem zweiten Zustand haltbare Steuereinrichtung umfasst,
gekennzeichnet durch die folgenden Merkmale:
a) die Auswertungseinrichtung (70, 70a) kann dem Auslöseelement ausreichend Strom zuführen und ein Auswertungssignal erzeugen, wenn das ausgewertete Ergebnis den vorbestimmten Auswertungszustand erfüllt hat,
b) die erste Einrichtung (50, 10a, 60) kann dem Auslöseelement bei deren Steuerung in einen niedrigleitenden Zustand kontinuierlich einen geringen Strom zuführen und kann dem Auslöseelement bei deren Steuerung in einen hochleitenden Zustand einen ausreichenden Strom zuführen,
c) wobei der erste Zustand der Steuereinrichtung (10b, 79c, 80, 80a bis 80f) ein Zustand zum Steuern der ersten Einrichtung (10a, 50, 60) in den niedrigleitenden Zustand ist, und der zweite Zustand ein Zustand zum Steuern der ersten Einrichtung in den hochleitenden Zustand ist, wobei die zweite Einrichtung vorgesehen ist, um den ersten Zustand der Steuereinrichtung (10b, 79c, 80, 80a bis 80f) zu bewirken, wenn die Auswertungseinrichtung (70, 70a) kein Auswertungssignal erzeugt, und um den zweiten Zustand der Steuereinrichtung ansprechend auf das Auswertungssignal der Auswertungseinrichtung zu bewirken und
d) in welcher eine dritte Einrichtung (30, 40, 40a) bereitgestellt ist, um den Betrieb der ersten Einrichtung beim Erfassen eines vorbestimmten Verbotszustandes zu sperren, um die Zuführung des ausreichenden Stroms zu dem Auslöseelement (Bg) zu sperren.

2. Auslöseeschaltung nach Anspruch 1, in welcher die Leistungsquelle eine Batterie (Ba) und ein Kondensator (20) ist, wobei der Kondensator von der Batterie durch den Strompfad geladen wird und
in welcher dem Auslöseelement ein Strom durch den Strompfad von wenigstens der Batterie oder dem Kondensator zugeführt wird.

3. Auslöseschaltung nach einem der Ansprüche 1 oder 2,
dadurch **gekennzeichnet,** daß die dritte Einrichtung eine Einrichtung (30) zum Erfassen eines Absinkens einer elektrischen Spannung von wenigstens der Batterie oder dem Kondensator enthält, um daraus ein Erfassungssignal zu erzeugen, wobei die dritte Einrichtung den Betrieb der ersten Einrichtung in Ansprechen auf das Erfassungssignal sperrt.

4. Auslöseschaltung nach einem der Ansprüche 1 bis 3,
dadurch **gekennzeichnet,** daß die erste Einrichtung eine Transistorschaltungseinrichtung (50, 10a, 60) ist.

5. Auslöseschaltung nach einem der Ansprüche 1 bis 3,
dadurch **gekennzeichnet**, daß die Auswertungseinrichtung einen Beschleunigungssensor (71) zum Bereitstellen eines Beschleunigungssignals in Ansprechen auf Beschleunigungen des Fahrzeugs enthält und eine Auswertungsschaltung (72 bis 78) enthält zum Auswerten des Beschleunigungssignals des Beschleunigungssensors im Verhältnis zu dem vorbestimmten Auswertungszustand und zum Erzeugen eines Auswertungssignals, wenn das ausgewertete Ergebnis den vorbestimmten Auswerungszustand erfüllt hat.

6. Auslöseschaltung nach einem der Ansprüche 1 bis 5,
in welcher die erste Einrichtung eine Halbleitereinrichtung (50) und einen Widerstand (10a) mit einem hohen Widerstandswert enthält, die parallel zueinander innerhalb des Strompfades bereitgestellt sind, wobei die Halbleitereinrichtung bei deren Steuerung in einen niedrigleitenden Zustand dem Auslöseelement aus der Leistungsquelle durch den Widerstand kontinuierlich einen geringen Strom zuführt und bei deren Steuerung in einen hochleitenden Zustand durch diese dem Auslöseelement von der Leistungsquelle den ausreichenden Strom zuführt,
in welcher die Steuereinrichtung in dem ersten Zustand haltbar ist, um die Halbleitereinrichtung in den niedrigleitenden Zustand zu steuern und in dem zweiten Zustand haltbar ist, um die Halbleitereinrichtung in den hochleitenden Zustand zu steuern, und
in welcher die dritte Einrichtung den Betrieb der Halbleitereinrichtung in Ansprechen auf das Erfassen des vorbestimmten Verbotszustands sperrt. (Fig. 2)

7. Auslöseschaltung nach einem der Ansprüche 4 oder 6,
dadurch **gekennzeichnet,** daß die Halbleitereinrichtung (50) der Transistorschaltungseinrichtung einen Transistor (50) enthält.

8. Auslöseschaltung nach einem der Ansprüche 1 bis 7,
dadurch **gekennzeichnet,** daß die erste Einrichtung enthält:
eine Schalteinrichtung (60) und einen Widerstand (10a) mit einem hohen Widerstandswert, die parallel zueinander innerhalb des Strompfades bereitgestellt sind, wobei die Schalteinrichtung beim Auslösen in Ansprechen auf ein Ansteigen der Fahrzeuggeschwindigkeit bis zu einem vorbestimmten unteren Wert einen Nebenschluß zu dem Widerstand bildet, und
die Halbleitereinrichtung (50), die zu der Schalteinrichtung und dem Widerstand gehört und dem Auslöseelement bei deren Steuerung in einen niedrigleitenden Zustand durch diese von der Leistungsquelle kontinuierlich einen geringen Strom zuführt und dem Auslöseelement bei deren Steuerung in einen hochleitenden Zustand durch diese von der Leistungsquelle den ausreichenden Strom zuführt, wenn zu dem Widerstand der Nebenschluß gebildet wird,
in welcher die Steuereinrichtung (80c, 10b) in dem ersten Zustand haltbar ist, um die Halbleitereinrichtung in den niedrigleitenden Zustand zu steuern und in dem zweiten Zustand haltbar ist, um den halbleitenden Zustand zu steuern, und
in welcher die dritte Einrichtung (30, 40) den Betrieb der Halbleitereinrichtung in Ansprechen auf das Erfassen des vorbestimmten Verbotszustands sperrt. (Fig. 4)

9. Auslöseschaltung nach einem der Ansprüche 1 bis 7,
dadurch **gekennzeichnet,** daß die zweite Einrichtung eine Halbleitereinrichtung (79) enthält, die nichtleitend ist, wenn die Auswertungseinrichtung kein Auswertungssignal erzeugt und in Ansprechen auf das Auswertungssignal der Auswertungseinrichtung leitend ist, und
in welcher die Steuereinrichtung eine Vorstrom- bzw. Vorspannungs-Schaltungseinrichtung (10b, 80, 80a, 80b) ist, die in Ansprechen auf das Nichtleiten der Halbleitereinrichtung die erste Einrichtung in den niedrigleitenden Zustand vorbestromt bzw. mit Vorspannung versieht und in Ansprechen auf das Leiten der Halbleitereinrichtung die erste Einrichtung in den hochleitenden Zustand vorbestromt bzw. mit Vorspannung versieht. (Fig. 2)

10. Auslöseschaltung nach einem der Ansprüche 1 bis 3 oder 5,
dadurch **gekennzeichnet,** daß die erste Einrichtung eine Halbleitereinrichtung (50) und einen Widerstand (10a) mit einem hohen Widerstandswert enthält, die parallel zueinander innerhalb des Strompfades bereitgestellt sind, wobei die Halbleitereinrichtung dem Auslöseelement aus der Leistungsquelle durch den Widerstand bei deren Steuerung in einen niedrigleitenden Zustand kontinuierlich einen geringen Strom zuführt und dem Auslöseelement von der Leistungsquelle durch diese bei deren Steuerung in den hochleitenden Zustand den ausreichenden Strom zuführt,
in welcher die zweite Einrichtung eine Halbleitereinrichtung (79) enthält, die nichtleitend ist, wenn die Auswertungseinrichtung kein Auswertungssignal erzeugt, und in Ansprechen auf das Auswertungssignal der Auswertungseinrichtung leitend ist,
in welcher die Steuereinrichtung eine Widerstandseinrichtung (80d bis 80f) enthält, die in Ansprechen auf das Nichtleiten der zweitgenannten Halbleitereinrichtung die erstgenannte Halbleitereinrichtung in den niedrigleitenden Zustand vorbestromt bzw. vorspannt und in Ansprechen auf das Leiten der zweitgenannten Halbleitereinrichtung die erstgenannte Halbleitereinrichtung in den hochleitenden Zustand vorbestromt bzw. vorspannt, und
in welcher die dritte Einrichtung (30, 40a) die zweitgenannte Halbleitereinrichtung in Ansprechen auf das Erfassen des vorbestimmten Verbotszustands sperrt. (Fig. 5)

11. Auswertungsschaltung nach einem der Ansprüche 4, 6, oder 7, dadurch **gekennzeichnet,** daß die Transistorschaltungseinrichtung einen innerhalb des Strompfads bereitgestellten Transistor (50) enthält, wobei die Transistorschaltungseinrichtung dem Auslöseelement aus der Leistungsquelle durch den Transistor bei Steuerung des Transistors in seinen niedrigleitenden Zustand kontinuierlich einen geringen Strom zuführt und dem Auslöseelement aus der Leistungsquelle durch den Transistor bei Steuerung des Transistors in seinen hochleitenden Zustand den ausreichenden Strom zuführt,
in welcher die zweite Einrichtung eine Halbleitereinrichtung (79) enthält, die nichtleitend ist, wenn die Auswertungseinrichtung kein Auswertungssignal erzeugt und in Ansprechen auf das Auswertungssignal der Auswertungseinrichtung leitend ist,
in welcher die Steuereinrichtung eine Vorstrom- bzw. Vorspannungs-Schaltungseinrichtung (10b, 80a, 80b) ist mit einer an der Basis des Transistors angeschlossenen Widerstandsschaltung und einer innerhalb der Widerstandsschaltung bereitgestellten Diode (80), wobei die Vorstrom- bzw. Vorspannungs-Schaltungseinrichtung in Ansprechen auf das Nichtleiten der Halbleitereinrichtung das Nichtleiten der Diode mittels der Widerstandsschaltung so bewirkt, daß der Transistor in seinen niedrigleitenden Zustand gesteuert ist, und in Ansprechen auf das Leiten der Halbleitereinrichtung das Leiten der Diode mittels der Widerstandsschaltung so bewirkt, daß der Transistor in seinen hochleitenden Zustand gesteuert ist, und
in welcher die dritte Einrichtung (30, 40) den Betrieb des Transistors in Ansprechen auf das Erfassen des vorbestimmten Verbotszustands sperrt.

12. Auslöseschaltung nach Anspruch 11, dadurch **gekennzeichnet,** daß die Transistorschaltungseinrichtung eine Schalteinrichtung (60) enthält, die innerhalb des Strompfades in Serie zu dem Transistor bereitgestellt ist und in Ansprechen auf einen Anstieg der Fahrzeuggeschwindigkeit auf einen vorbestimmten unteren Wert die elektrische Leistungszuführung zu dem Zündelement durch den Transistor bewirkt.

13. Auslöseschaltung nach Anspruch 12, ferner enthaltend eine Einrichtung (60a) zum Bestimmen eines Defektes oder einer Fehlfunktion der Schalteinrichtung als Funktion einer auf dem Strompfad auftretenden elektrischen Spannung.

14. Auslöseschaltung nach einem der Ansprüche 4, 6 oder 7, in welcher die Transistorschaltungseinrichtung einen innerhalb des Strompfades bereitgestellten Transistor (50) enthält, wobei die Transistorschaltungseinrichtung dem Auslöseelement aus der Leistungsquelle durch den Transistor beim Steuern des Transistors in seinen niedrigleitenden Zustand kontinuierlich einen geringen Strom zuführt und dem Auslöseelement aus der Leistungsquelle durch den Transistor beim Steuern des Transistors in seinen hochleitenden Zustand den ausreichenden Strom zuführt,
in welcher die zweite Einrichtung eine Halbleitereinrichtung (79) enthält, die nichtleitdend ist, wenn die Auswertungsschaltung kein Auswertungssignal erzeugt, und in Ansprechen auf das Auswertungssignal der Auswertungseinrichtung leitend ist,
in welcher die Steuereinrichtung eine Widerstandsschaltung (80d bis 80f) enthält, die an die Basis des Transistors angeschlossen ist und den Transistor in Ansprechen auf das Nichtleiten der Halbleitereinrichtung in den niedrigleitenden Zustand vorbestromt bzw. vorspannt und in Ansprechen auf das Leiten der Halbleitereinrichtung den Transistor in den hochleitenden Zustand vorbestromt bzw. vorspannt und
in welcher die dritte Einrichtung das Leiten der Halbleitereinrichtung in Ansprechen auf das Erfassen des vorbestimmten Verbotszustands sperrt.

## Revendications

1. Circuit de déclenchement pour un dispositif de sécurité, notamment pour un véhicule, ayant un élément de déclenchement (10) alimenté par un courant suffisant pour activer celui-ci à partir d'une source d'énergie électrique (Ba, 20) par l'intermédiaire d'un chemin conducteur du courant (La), le dispositif de sécurité étant actionné en réponse à l'activation de l'élément de déclenchement (Bg) pour protéger des passagers d'un véhicule,
avec des moyens d'évaluation (70, 70A) pour évaluer l'état réel du véhicule en relation avec un état prédéterminé d'évaluation;
avec des premiers moyens (50, 10a, 60) prévus dans ledit chemin conducteur du courant pour fournir un courant à l'élément de déclenchement à partir de ladite source d'énergie par l'intermédiaire dudit chemin conducteur du courant (La); et
avec des deuxièmes moyens comportant des moyens de commande pouvant être maintenus dans un premier et un deuxième état,
caractérisé en ce qu'il présente les particularités suivantes :
a) lesdits moyens d'évaluation (70, 70A) sont adaptés pour fournir un courant suffisant à l'élément de déclenchement et pour produire un signal d'évaluation lorsque le résultat évalué a satisfait à l'état prédéterminé d'évaluation;
b) lesdits premiers moyens (50, 10a, 60) sont adaptés pour fournir un courant de très faible intensité en permanence à l'élément de déclenchement lorsqu'ils sont commandés pour être mis dans un état faiblement conducteur de ceux-ci, et pour fournir un courant suffisant à l'élément de déclenchement lorsqu'ils sont commandés pour être mis dans un état fortement conducteur de ceux-ci;
c) ledit premier état desdits moyens de commande (10b, 79c, 80, 80a-80f) est un état pour commander lesdits premiers moyens (10a, 50, 60) pour les mettre dans l'état faiblement conducteur, et ledit deuxième état est un état pour commander lesdits premiers moyens pour les mettre dans l'état fortement conducteur, lesdits deuxièmes moyens étant agencés pour réaliser le premier état desdits moyens de commande (10b, 79c, 80, 80a-80f) lorsque lesdits moyens d'évaluation (70, 70A) ne produisent pas de signal d'évaluation, et pour réaliser le deuxième état desdits moyens de commande en réponse au signal d'évaluation issu desdits moyens d'évaluation; et
d) dans lequel des troisièmes moyens (30, 40, 40A) sont prévus pour interdire le fonctionnement desdits premiers moyens lors de la détection d'un état prédéterminé d'interdiction pour interdire la fourniture dudit courant suffisant à l'élément de déclenchement (Bg).

2. Circuit de déclenchement selon la revendication 1, dans lequel ladite source d'énergie est constituée par une batterie (Ba) et un condensateur (20), le condensateur étant chargé par ladite batterie par l'intermédiaire dudit chemin conducteur du courant; et
dans lequel l'élément de déclenchement est alimenté par un courant par l'intermédiaire dudit chemin conducteur du courant à partir d'au moins une dite batterie et un dit condensateur.

3. Circuit de déclenchement selon l'une des revendications 1 et 2, caractérisé en ce que lesdits troisièmes moyens comportent des moyens (30) pour détecter une diminution d'une tension électrique issue d'au moins une dite batterie et un dit condensateur pour produire un signal de détection issu de ceux-ci, lesdits troisièmes moyens interdisant le fonctionnement desdits premiers moyens en réponse su signal de détection.

4. Circuit de déclenchement selon l'une des revendications 1 à 3, caractérisé en ce que lesdits premiers moyens sont des moyens formant circuit à transistor (50, 10a, 60).

5. Circuit de déclenchement selon l'une des revendications 1 à 3, caractérisé en ce que lesdits moyens d'évaluation comportent un capteur d'accélération (71) pour fournir un signal d'accélération en réponse à des accélérations du véhicule, et un circuit d'évaluation (72-78) pour évaluer le signal d'accélération issu dudit capteur d'accélération en relation avec l'état prédéterminé d'évaluation et pour produire un signal d'évaluation lorsque le résultat évalué a satisfait à l'état prédéterminé d'évaluation.

6. Circuit de déclenchement selon l'une des revendications 1 à 5, dans lequel lesdits premiers moyens comportent des moyens à semiconducteur (50) et une résistance (10a) à grande valeur ohmique qui sont montés en parallèle entre eux dans ledit chemin conducteur du courant, lesdits moyens à semiconducteur fournissant un courant de très faible intensité en permanence à l'élément de déclenchement à partir de ladite source d'énergie par l'intermédiaire de ladite résistance lorsqu'ils sont commandés pour être mis dans un état faiblement conducteur de ceux-ci, et fournissant ledit courant suffisant à l'élément de déclenchement à partir de ladite source d'énergie par l'intermédiaire de ceux-ci lorsqu'ils sont commandés pour être mis dans un état fortement conducteur de ceux-ci,
dans lequel lesdits moyens de commande peuvent être maintenus dans le premier état pour commander lesdits moyens à semiconducteur pour les mettre dans l'état faiblement conducteur, et peuvent être maintenus dans le deuxième état pour commander lesdits moyens à semiconducteur pour les mettre dans l'état fortement conducteur; et
dans lequel lesdits troisièmes moyens interdisent le fonctionnement desdits moyens à semiconducteur en réponse à la détection de l'état prédéterminé d'interdiction. (figure 2)

7. Circuit de déclenchement selon l'une des revendications 4 et 6, caractérisé en ce que lesdits moyens à semiconducteur (50) desdits moyens formant circuit à transistor comportent un transistor (50).

8. Circuit de déclenchement selon l'une des revendications 1 à 7, caractérisé en ce que lesdits premiers moyens comportent :
- des moyens formant commutateur (60) et une résistance (10a) à grande valeur ohmique qui sont prévus en parallèle entre eux dans ledit chemin conducteur du courant, lesdits moyens formant commutateur pontant ladite résistance lorsqu'ils sont actionnés en réponse à une augmentation de la vitesse du véhicule jusqu'à une faible valeur prédéterminée; et
- des moyens à semiconducteur (50) associés auxdits moyens formant commutateur et à ladite résistance pour fournir un courant de très faible intensité en permanence à l'élément de déclenchement à partir de ladite source d'énergie par l'intermédiaire de ceux-ci lorsqu'ils sont commandés pour être mis dans un état faiblement conducteur de ceux-ci, et pour fournir ledit courant suffisant à l'élément de déclenchement à partir de ladite source d'énergie par l'intermédiaire de ceux-ci lorsqu'ils sont commandés pour être mis dans un état fortement conducteur de ceux-ci lorsque ladite résistance est pontée,
dans lequel lesdits moyens de commande (80c, 10b) peuvent être maintenus dans le premier état pour commander lesdits moyens à semiconducteur pour les mettre dans l'état faiblement conducteur, et peuvent être maintenus dans le deuxième état pour commander ledit état semiconducteur; et
dans lequel lesdits troisièmes moyens (30, 40) interdisent le fonctionnement desdits moyens à semiconducteur en réponse à la détection de l'état prédéterminé d'interdiction. (figure 4)

9. Circuit de déclenchement selon l'une dos revendications 1 à 7, caractérisé en ce que lesdits deuxièmes moyens comportent des moyens à semiconducteur (79) qui sont non conducteurs lorsque lesdits moyens d'évaluation ne produisent pas de signal d'évaluation, et conducteurs en réponse au signal d'évaluation issu desdits moyens d'évaluation; et
dans lequel lesdits moyens de commande sont des moyens formant circuit de polarisation (10b, 80, 80a, 80b) sensibles à la non-conduction desdits moyens à semiconducteur pour polariser lesdits premiers moyens pour les mettre dans l'état faiblement conducteur, et sensibles à la conduction desdits moyens à semiconducteur pour polariser lesdits premiers moyens pour les mettre dans l'état fortement conducteur. (figure 2)

10. Circuit de déclenchement selon une des revendications 1 à 3 ou 5, caractérisé en ce que lesdits premiers moyens comportent des moyens à semiconducteur (50) et une résistance (10a) avec une grande valeur ohmique qui sont montés en parallèle entre eux dans ledit chemin conducteur du courant, lesdits moyens à semiconducteur fournissant un courant de très faible intensité en permanence à l'élément de déclenchement à partir de ladite source d'énergie par l'intermédiaire de ladite résistance lorsqu'ils sont commandés pour être mis dans un état faiblement conducteur de ceux-ci, et pour fournir ledit courant suffisant à l'élément de déclenchement à partir de ladite source d'énergie par l'intermédiaire de ceux-ci lorsqu'ils sont commandés pour être mis dans un état fortement conducteur de ceux-ci,
dans lequel lesdits deuxièmes moyens comportent des moyens à semiconducteur (79) qui sont non conducteurs lorsque lesdits moyens d'évaluation ne produisent pas de signal d'évaluation, et conducteurs en réponse au signal d'évaluation issu desdits moyens d'évaluation,
dans lequel lesdits moyens de commande comportent des moyens formant résistance (80d-80f) sensibles à la non-conduction desdits moyens à semiconducteur mentionnés en second pour polariser lesdits moyens à semiconducteur mentionnés en premier pour les mettre l'état faiblement conducteur, et sensibles à la conduction desdits moyens à semiconducteur mentionnés en second pour polariser lesdits moyens à semiconducteur mentionnés en premier pour les mettre dans l'état fortement conducteur; et
dans lequel lesdits troisièmes moyens (30, 40A) interdisent le fonctionnement desdits moyens à semiconducteur mentionnés en second en réponse à la détection de l'état prédéterminé d'interdiction. (figure 5).

11. Circuit de déclenchement selon l'une des revendications 4, 6 et 7, caractérisé en ce que lesdits moyens formant circuit à transistor comportent un transistor (50) monté dans ledit chemin conducteur du courant, lesdits moyens formant circuit à transistor fournissant un courant de très faible intensité en permanence à l'élément de déclenchement à partir de ladite source d'énergie par l'intermédiaire dudit transistor lorsque ledit transistor est commandé pour être mis dans un état faiblement conducteur de celui-ci, et pour fournir ledit courant suffisant à l'élément de déclenchement à partir de ladite source d'énergie par l'intermédiaire dudit transistor lorsque ledit transistor est commandé pour être mis dans un état fortement conducteur de celui-ci;
dans lequel lesdits deuxièmes moyens comportent des moyens à semiconducteur (79) qui sont non conducteurs lorsque lesdits moyens d'évaluation ne produisent pas de signal d'évaluation, et conducteurs en réponse au signal d'évaluation issu desdits moyens d'évaluation;
dans lequel lesdits moyens de commande sont des moyens formant circuit de polarisation (10b, 80a, 80b) ayant un circuit à résistance connecté à la base dudit transistor, et une diode (80) montée dans ledit circuit à résistance, lesdits moyens formant circuit de polarisation étant sensibles à la non-conduction desdits moyens à semiconducteur pour réaliser la non-conduction de ladite diode par l'action dudit circuit à résistance de telle manière que ledit transistor soit commandé pour être mis dans son état faiblement conducteur, et sensibles à la conduction desdits moyens à semiconducteur pour réaliser la conduction de ladite diode par l'action dudit circuit à résistance de telle manière que ledit transistor soit commandé pour être mis dans son état fortement conducteur; et
dans lequel lesdits troisièmes moyens (30, 40) interdisent le fonctionnement dudit transistor en réponse à la détection de l'état prédéterminé d'interdiction.

12. Circuit de déclenchement selon la revendication 11, caractérisé en ce que lesdits moyens formant circuit à transistor comportent des moyens formant commutateur (60) montés dans ledit chemin conducteur du courant en série avec ledit transistor et pouvant être fermés en réponse à une augmentation de la vitesse du véhicule jusqu'à une faible valeur prédéterminée pour réaliser l'alimentation en énergie électrique de l'élément de déclenchement par l'intermédiaire dudit transistor.

13. Circuit de déclenchement selon la revendication 12, comprenant en outre des moyens (60a) pour déterminer un défaut ou un mauvais fonctionnement desdits moyens formant commutateur en fonction d'une tension électrique apparaissant dans ledit chemin conducteur du courant.

14. Circuit de déclenchement selon l'une des revendications 4, 6 et 7, dans lequel lesdits moyens formant circuit à transistor comportent un transistor (50) monté dans ledit chemin conducteur du courant, lesdits moyens formant circuit à transistor fournissant un courant de très faible intensité en permanence à l'élément de déclenchement à partir de ladite source d'énergie par l'intermédiaire dudit transistor lorsque ledit transistor est commandé pour être mis dans un état faiblement conducteur de celui-ci, et pour fournir ledit courant suffisant à l'élément de déclenchement à partir de ladite source d'énergie par l'intermédiaire dudit transistor lorsque ledit transistor est commandé pour être mis dans un état fortement conducteur de cellui-ci;
dans lequel lesdits deuxièmes moyens comportent des moyens à semiconducteur (79) qui sont non conducteurs lorsque lesdits moyens d'évaluation ne produisent pas de signal d'évaluation, et conducteurs en réponse au signal d'évaluation issu desdits moyens d'évaluation;
dans lequel lesdits moyens de commande comportent un circuit à résistance (80d-80f) connecté à la base dudit transistor pour polariser ledit transistor pour le mettre dans l'état faiblement conducteur en réponse à la non-conduction desdits moyens à semiconducteur, et pour polariser ledit transistor pour le mettre dans l'état fortement conducteur en réponse à la conduction desdits moyens à semiconducteur; et
dans lequel lesdits troisièmes moyens interdisent la conduction desdits moyens à semiconducteur en réponse à la détection de l'état prédéterminé d'interdiction.
